(19) Europäisches Patentamt
European Patent Office
Office européen des brevets

(11) **EP 4 746 664 A1**

(12) **DEMANDE DE BREVET EUROPEEN**

(43) Date de publication:
20.05.2026 Bulletin 2026/21

(21) Numéro de dépôt: 25215340.8

(22) Date de dépôt: **12.11.2025**

(51) Classification Internationale des Brevets (IPC):
*H10N 10/01* (2023.01)     *H10N 10/17* (2023.01)
*B22F 10/28* (2021.01)     *B22F 5/10* (2006.01)
*B22F 7/06* (2006.01)      *B22F 7/08* (2006.01)
*B22F 10/25* (2021.01)

(52) Classification Coopérative des Brevets (CPC):
**H10N 10/01; B22F 5/106; B22F 7/06; B22F 7/08;
B22F 10/25; H10N 10/17;** B22F 10/40; B22F 12/55;
B22F 12/58; C22C 1/0483

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH LA MA MD TN**

(30) Priorité: **14.11.2024 FR 2412442**

(71) Demandeur: **Commissariat à l'Energie Atomique
et aux Energies
Alternatives
75015 Paris (FR)**

(72) Inventeurs:
• **SAVELLI, Guillaume
38054 GRENOBLE (FR)**
• **BAUDRY, Maxime
38054 GRENOBLE (FR)**
• **ROUX, Guilhem
38054 GRENOBLE (FR)**

(74) Mandataire: **Ipsilon
12, Avenue d'Italie
75013 Paris (FR)**

(54) **PROCÉDÉ DE FABRICATION D'UNE STRUCTURE THERMOÉLECTRIQUE PAR DÉPÔT SOUS ÉNERGIE CONCENTRÉE**

(57)     L'invention concerne un procédé de fabrication d'un module thermoélectrique (10) permettant de générer un effet thermoélectrique, comprenant au moins les étapes de :
(a) Fourniture d'un substrat (20),
(b) Formation sur le substrat (20) d'une pluralité d'unités thermoélectriques (15) comportant chacune deux éléments thermoélectriques (11, 12) dopés selon des types de dopage différents, les deux éléments thermoélectriques (11, 12) étant reliés électriquement entre eux du côté du substrat (20) et/ou du côté opposé au substrat (20), les deux éléments thermoélectriques (11, 12) étant au moins partiellement formés par une méthode de dépôt sous énergie concentrée.

[Fig 1]

Fig. 1

EP 4 746 664 A1

## Description

### Domaine technique

La présente invention concerne un procédé de fabrication d'une structure thermoélectrique par une méthode de dépôt sous énergie concentrée.

### Technique antérieure

De manière connue, les modules thermoélectriques sont généralement constitués de matériaux dopés de type p et de type n, et comporte des plots agencés sur un substrat. Les plots sont connectés électriquement en série par des jonctions métalliques et thermiquement en parallèle.

Les performances électriques d'un dispositif thermoélectrique en mode générateur sont données par :

a) Une résistance électrique interne Rint de jonction entre les matériaux dopés de type p et de type n déterminée de la manière suivante :

$$Rint = N \times \rho_{np} \times H/A + Rc + Rmet$$

Avec N le nombre de jonctions entre les matériaux dopés de type p et type n de la structure, $\rho_{np}$ est la densité de charges au niveau des jonctions p-n, H la longueur d'une ligne ou d'un plot, A la section d'une ligne ou d'un plot Rc la résistance totale des contacts et Rmet la résistance totale des jonctions métalliques,

b) Une puissance électrique utile $Pu = V^2/4Rint$.

Pour disposer d'une puissance électrique utile élevée, il faut donc avoir notamment une résistance électrique Rint faible et donc limiter la contribution à la résistance des résistances totales des contacts Rc et la résistance totale des jonctions métalliques.

La fabrication de modules thermoélectriques est généralement réalisée à partir de plusieurs étapes : la fabrication de matériaux thermoélectriques notamment par frittage, la mise en forme des plots, leur métallisation et l'assemblage avec le substrat.

Il est connu de EP3985745 un procédé de fabrication de dispositif thermoélectrique. Le procédé inclut plusieurs étapes parmi lesquelles la fabrication de pièces en forme de peigne, leur assemblage mécanique et électrique, suivi de la découpe pour former les jonctions thermoélectriques.

FR3140994 concerne un procédé de fabrication de structures thermoélectriques utilisant des techniques de fabrication additive telles que la fusion laser sur lit de poudres ou le frittage sélectif par laser et peut inclure une étape de retrait du substrat pour obtenir la structure finale.

FR3140993 décrit également un procédé de fabrication de structures thermoélectriques utilisant également des techniques de fabrication additives, de préférence la fusion laser sur lit de poudre ou de frittage sélectif par laser. Ces procédés de fabrication nécessitent des étapes d'assemblage et ne permettent pas de fabriquer des dispositifs thermoélectriques sur des surfaces de formes complexes.

L'article J. Lee, S. Choo, H. Ju, J. Hong, S. E. Yang, F. Kim, D. H. Gu, J. Jang, G. Kim, S. Ahn, J. E. Lee, S. Y. Kim, H. G. Chae, J. S. Son, Doping-Induced Viscoelasticity in PbTe Thermoelectric Inks for 3D Printing of Power-Generating Tubes. Adv. Energy Mater. 2021, 11, 2100190. décrit des modules thermoélectriques fabriqués par une méthode de fabrication additive, notamment par solution printing, une méthode d'impression 3D. Des particules PbTe sont synthétisées, puis des encres colloïdales sont réalisées à partir de ces particules. Les encres sont ensuite extrudées à l'aide d'une imprimante 3D, puis séchées et traitées thermiquement. Les objets obtenus sont ensuite assemblés pour former des modules thermoélectriques.

L'article Hue et al. ACS Applied Materials and Interfaces 2023, Vol 15/Issue 32, 3D Printing of Bi2Te3-Based Thermoelectric Materials with High Performance and Shape Controllability décrit également des modules thermoélectriques fabriqués par une méthode de fabrication additive, en particulier par fusion sélective au laser, pour obtenir des modules thermoélectriques en forme de demi-anneaux.

Il existe donc un besoin de développer un procédé de fabrication de modules thermoélectriques permettant la fabrication de modules thermoélectriques sans étapes d'assemblage, de forme complexe pour s'adapter à différentes formes de support, tout en améliorant les propriétés thermoélectriques des modules thermoélectriques.

## Exposé de l'invention

La présente invention répond à ce besoin grâce à un procédé de fabrication d'un module thermoélectrique permettant de générer un effet thermoélectrique, comprenant au moins les étapes de :

(a) Fourniture d'un substrat,
(b) Formation sur le substrat d'une pluralité d'unités thermoélectriques comportant chacune deux éléments thermoélectriques dopés selon des types de dopage différents, les deux éléments thermoélectriques étant reliés électriquement entre eux du côté du substrat et/ou du côté opposé au substrat, les deux éléments thermoélectriques étant au moins partiellement formés par une méthode de dépôt sous énergie concentrée.

L'invention concerne également un module thermoélectrique fabriqué d'après le procédé tel que mentionné ci-dessus.

L'utilisation d'une méthode de dépôt sous énergie concentrée permet de réaliser des dépôts sur une grande quantité de types de forme de substrat, notamment sur des substrats cylindriques, ce qui n'est pas possible ou complexe avec d'autres procédés de fabrication additive comme la fusion laser sur lit de poudre. Cela permet de construire des modules directement sur des substrats adaptés à la forme de la source thermique, notamment de chaleur ou de froid, facilitant la fabrication de tels modules et améliorant ainsi les rendements.

Ainsi, le dépôt sous énergie concentrée permet la fabrication de modules de formes complexes, comme des modules cylindriques, qui peuvent être plus adaptés à certaines sources de chaleur à dissiper.

Par ailleurs, la technique de dépôt sous énergie concentrée peut se faire avec une pluralité de buses émettant de la poudre des matériaux à déposer vers la zone de fusion comme nous le verrons par la suite. Le fait qu'il y ait plusieurs buses permet d'envisager le dépôt de matériaux différents par les différentes buses. Cela permet notamment de former les éléments thermoélectriques dopés p et les éléments thermoélectriques dopés n sans avoir à changer la poudre dans le dispositif, à partir de buses différentes. Cela simplifie la fabrication et améliore la précision de fabrication et de jonction entre les deux matériaux. Cela peut améliorer les performances énergétiques du module thermoélectrique, notamment en diminuant les résistances électriques aux jonctions.

Le dépôt sous énergie concentrée permet également d'avoir une grande versatilité de formes d'unités thermoélectriques réalisables. Cela permet une grande versatilité de configuration des modules thermoélectriques et de leurs performances et ainsi de pouvoir fabriquer un module thermoélectrique sur mesure en fonction des performances recherchées, de la forme et de l'encombrement disponible. Certaines formes d'éléments thermoélectriques peuvent en particulier améliorer l'encombrement des unités thermoélectriques dans un module, permettant une meilleure optimisation de l'espace dans le module thermoélectrique et ainsi d'améliorer les performances du module pour un même encombrement.

Il est ainsi possible selon la situation, notamment le cahier des charges et l'environnement, d'avoir des modules dont la forme et les dimensions sont adaptées à chaque situation.

Le dépôt sous énergie concentrée permet également une grande versatilité de schéma électrique entre les éléments thermoélectriques, notamment de relier les éléments thermoélectriques en série ou en parallèle pour adapter les performances.

## Jonction électrique

Les deux éléments thermoélectriques d'une même unité thermoélectrique peuvent être reliés électriquement entre eux par contact direct entre eux ou par une jonction électrique interne.

Les éléments thermoélectriques peuvent être composés d'un ou de plusieurs plots de même dopage. De préférence, les éléments thermoélectriques sont composés d'un seul plot. En variante, les éléments thermoélectriques sont composés de plusieurs plots, ces derniers étant de même dopage et reliés électriquement à la fois du côté du substrat et du côté opposé au substrat, les plots étant alors connectés en parallèle entre eux.

Chaque élément thermoélectrique de chaque unité thermoélectrique peut être en outre relié électriquement à un élément thermoélectrique adjacent de dopage différent d'une autre unité thermoélectrique différente ou à un connecteur électrique par contact direct ou par une jonction électrique externe.

De préférence, chacune des deux extrémités longitudinales des éléments thermoélectriques est reliée à un autre élément thermoélectrique de dopage différent ou à un connecteur électrique.

Les jonctions électriques internes et/ou les jonctions électriques externes peuvent être formées par le dépôt local entre les deux éléments thermoélectriques d'une couche d'un mélange des deux matériaux composant les deux éléments thermoélectriques ou le dépôt d'une piste métallique en contact avec les deux éléments thermoélectriques. Dans le cas d'une couche d'un mélange des deux matériaux composant les deux éléments thermoélectriques entre les deux éléments thermoélectriques, cette couche peut s'étendre entre deux surfaces latérales des éléments thermoélectriques en regard.

Le dépôt du mélange peut se faire par dépôt sous énergie concentrée, notamment comme cela est décrit dans la suite.

Dans le cas de contact direct ou de jonction électrique par mélange entre les éléments thermoélectriques de dopages différents, la surface médiane de l'unité thermoélectrique formant la séparation entre les deux éléments thermoélectriques peut être supérieure ou égale à 50%, mieux supérieure ou égale à 70%, de la surface d'une section transversale d'un élément thermoélectrique.

Lorsque les jonctions électriques internes et/ou les jonctions électriques externes sont des pistes métalliques en contact avec les deux éléments thermoélectriques. La piste métallique peut être déposée sous la forme d'une ou plusieurs couches discontinues par toute méthode de dépôt sur le substrat lorsqu'elle est du côté du substrat, et/ou sur les éléments thermoélectriques lorsqu'elle est du côté opposé au substrat.

## Unités thermoélectriques

De préférence, les deux éléments thermoélectriques de chaque unité thermoélectrique sont de structures sensiblement identiques à l'exception du dopage. De préférence, les deux éléments thermoélectriques sont en des matériaux identiques dopés différemment.

En variante, les deux éléments thermoélectriques de chaque unité thermoélectrique sont en des matériaux thermoélectriques différents dopés différemment.

De préférence, les deux éléments thermoélectriques de chaque unité thermoélectrique sont reliés entre eux à une de leurs extrémités.

Les éléments thermoélectriques peuvent être chacun en un unique matériau.

En variante, les éléments thermoélectriques sont multicouches. Ils peuvent comporter plusieurs couches de matériau différents dopés avec le même type de dopage. Cela peut permettre d'avoir des propriétés mécaniques, notamment de compatibilité thermique plus large en ayant une combinaison de matériaux thermoélectriques adaptée à des plages de températures différentes.

De préférence, les couches de matériaux différents dopés peuvent être séparées entre elles par une ou plusieurs structures d'interface.

La ou les structures d'interface peuvent comporter au moins une couche en un matériau formant une barrière de diffusion, notamment en cuivre ou nickel. De tels matériaux d'interface permettent de limiter la diffusion entre les deux éléments thermoélectriques, d'avoir un bon contact électrique, notamment peu résistif et de limiter les problèmes de dilatations thermiques entre les deux éléments thermoélectriques.

La structure d'interface peut être multicouche et comporter la couche en un matériau formant une barrière de diffusion en sandwich entre deux couches en un matériau thermoélectrique différent des matériaux thermoélectriques qu'elle sépare.

## Matériau

Les éléments thermoélectriques peuvent être en silicium (Si), en un alliage de silicium et germanium (SiGe), tellurure de bismuth (Bi2Te3), skuttérudites, en un alliage Half Heusler ou en Tellurure de plomb.

## Agencement des éléments thermoélectriques entre eux

Les éléments thermoélectriques peuvent être inclinés sur le substrat par rapport à l'axe perpendiculaire du substrat à leur base.

De préférence, dans le cas d'un contact direct des éléments thermoélectriques, les deux éléments thermoélectriques de chaque unité thermoélectrique sont inclinés sur le substrat par rapport à l'axe perpendiculaire du substrat à leur base dans des directions opposées. Ils peuvent être inclinés d'un angle $\alpha$ compris entre 5° et 70°. L'angle peut dépendre notamment des performances thermoélectriques attendues, de la tenue mécanique nécessaire, des matériaux et/ou de la hauteur des éléments.. Dans le cas d'un substrat de forme cylindrique de section circulaire, l'angle $\alpha$ peut être sensiblement égal à 360/n, n étant le nombre d'unités thermoélectriques agencées autour d'une section transversale du substrat.

Les éléments thermoélectriques reliés électriquement entre eux peuvent être espacés entre eux d'une distance non nulle sur toute leur hauteur. La distance peut être constante sur toute la hauteur. Les surfaces latérales en regard des éléments thermoélectriques peuvent être parallèles entre elles.

En variante, la distance entre les deux éléments thermoélectriques des unités thermoélectriques est variable.

Les éléments thermoélectriques adjacents peuvent présenter entre eux des espacements identiques. En variante, au moins un élément thermoélectrique présente des espacements différents avec les deux éléments thermoélectriques auxquels il est relié électriquement.

### Forme des éléments thermoélectriques

Les éléments thermoélectriques sont chacun de préférence allongés selon un axe longitudinal.

De préférence, les éléments thermoélectriques sont chacun symétriques par rapport à leur axe longitudinal.

Les éléments thermoélectriques peuvent être chacun symétriques par rapport à leur axe médian perpendiculaire à l'axe longitudinal. En variante, les éléments thermoélectriques sont chacun asymétriques par rapport audit axe médian.

Les éléments thermoélectriques peuvent tous être sensiblement de même forme.

Dans le cas d'éléments thermoélectriques asymétriques par rapport à leur axe médian, les deux éléments thermoélectriques des unités thermoélectriques peuvent être de formes complémentaires, notamment sensiblement imbriquables entre elles. Cela permet notamment un rapprochement des éléments thermoélectriques, ce qui réduit l'encombrement des unités thermoélectriques et permet d'avoir une plus grande quantité d'unités thermoélectriques par unité de surface. En variante, les deux éléments thermoélectriques des unités thermoélectriques peuvent être agencés dans le même sens.

En variante, au moins deux éléments thermoélectriques sont de formes différentes, notamment les deux éléments thermoélectriques de toutes les unités thermoélectriques sont de formes différentes, notamment complémentaires.

Les éléments thermoélectriques peuvent être de forme cylindrique à base quelconque avec une surface latérale s'étendant sur le substrat. La base du cylindre peut avoir la forme d'un quadrilatère, notamment d'un rectangle ou d'un trapèze isocèle, d'un sablier symétrique ou non par rapport au plan médian, d'un secteur circulaire sous forme de plots de forme sensiblement parallélépipédique ou présenter une surface à leur base inférieure ou égale

Les éléments thermoélectriques peuvent présenter, entre la base et le sommet, un rétrécissement localisé présentant une largeur latérale inférieure à la largeur du sommet et/ou de la base.

Les éléments thermoélectriques peuvent présenter une surface à leur base différente de la surface à leur sommet, notamment une des deux surfaces peut être plus grande que l'autre pour un contour sensiblement identique ou inversement.

Les éléments thermoélectriques peuvent comporter des branches s'étendant vers la base et/ou le sommet. Les branches peuvent être inclinées entre elles. Les branches peuvent se rejoindre à leur base. Les éléments thermoélectriques peuvent être en forme de Y ou de X. En variante, les branches sont distantes entre elles sur toute leur hauteur.

Les éléments thermoélectriques peuvent être creux ou pleins.

Les éléments thermoélectriques peuvent comporter des évidements, notamment des encoches latérales sur leur hauteur ou un évidement à leur base ou leur sommet. Cela permet notamment d'alléger le module thermoélectrique, de réduire la quantité de matière utilisé et d'augmenter la différence de température entre le sommet et la base des éléments thermoélectriques en conditions de fonctionnement.

La base des éléments thermoélectriques peut être de forme complémentaire du substrat, notamment être une surface courbe dans le cas d'un substrat cylindrique à base circulaire ayant le même rayon de courbure que le substrat.

Le sommet des éléments thermoélectriques peut être une surface plane ou courbe. La surface courbe du sommet peut être de même rayon de courbure que le substrat.

### Méthode de dépôt sous énergie concentrée

Le dépôt sous énergie concentrée peut être effectué à l'aide d'un dispositif comportant une unique buse de projection de matière à déposer ou une pluralité de buses de projection de matière à déposer. Comme mentionné précédemment, le fait qu'il y ait plusieurs buses permet d'envisager le dépôt de matériaux différents par les différentes buses. Cela permet notamment de former les éléments thermoélectriques dopés p et les éléments thermoélectriques dopés n sans avoir à changer la poudre dans le dispositif, à partir de buses différentes. Cela simplifie la fabrication et améliore la précision de fabrication et de jonction. Cela peut améliorer les performances énergétiques du module thermoélectrique, notamment en diminuant les résistances électriques aux jonctions électriques internes et/ou externes.

### Dépôt simultané

Dans le cas d'une pluralité de buses de projection, au moins deux buses peuvent être reliées à des réservoirs distincts, notamment chaque buse étant reliée à un réservoir qui lui est propre. Dans ce cas, les buses reliées à des réservoirs distincts peuvent être alimentées en matériau issu du réservoir de façon indépendante.

De préférence, dans ce cas, au moins une ou plusieurs premières buses sont reliées à un ou plusieurs réservoirs contenant un matériau dopé de type n pour former un des éléments thermoélectriques de chaque unité thermoélectrique au moins en partie et au moins une ou plusieurs autres deuxièmes buses sont reliées à un ou plusieurs réservoirs contenant un matériau dopé de type p pour former l'autre des éléments thermoélectriques de chaque unité thermoélectrique au moins en partie.

La ou les premières et la ou les deuxièmes buses peuvent être commandées de façon indépendante ou synchronisée pour ne déposer qu'un seul des deux matériaux ou un mélange des deux matériaux. Cela permet de limiter les manipulations du dispositif de dépôt pour la formation du module thermoélectrique, les matériaux dopés différemment pour les éléments thermoélectriques pouvant être introduits en amont dans le dispositif de dépôt et le dépôt pouvant se faire par programmation sans intervention extérieure. Cela permet également d'améliorer la précision de positionnement des éléments thermoélectriques et notamment de réaliser des jonctions électriques internes par contact direct avec une plus grande précision et donc une meilleure qualité de connexion.

Il est ainsi possible de déposer uniquement le matériau de type p, notamment pour former un élément thermoélectrique au moins en partie, ou uniquement le matériau de type n, notamment pour former l'autre élément thermoélectrique au moins en partie, ou de déposer un mélange des matériaux de type n et p, notamment pour former la jonction électrique interne et/ou externe entre les éléments thermoélectriques. Ainsi, le dépôt des deux éléments thermoélectriques d'une unité thermoélectrique au moins en partie peut se faire par projection de deux matériaux dopés selon des types de dopage différents par des buses différentes du dispositif de dépôt sous énergie concentrée.

La formation des unités thermoélectriques au moins en partie peut se faire par le dépôt alterné d'un matériau dopé de type p et d'un matériau dopé de type n pour chaque unité thermoélectrique en alternant la projection de matière par la ou les premières buses et la ou les deuxièmes buses. Cela permet notamment de fabriquer au moins partiellement le module sans avoir à manipuler le dispositif de dépôt et cela permet un meilleur repérage des éléments thermoélectriques entre eux.

La ou les jonctions électriques internes et/ou la ou les jonctions électriques externes reliant électriquement les deux parties d'éléments thermoélectriques peuvent être formées entre deux éléments thermoélectriques par le dépôt simultané des deux matériaux de dopages différents par la ou les premières et la ou les deuxièmes buses.

L'alternance des projections par le ou les premières buses et par le ou les deuxièmes buses telle que décrite précédemment peut comporter des plages de recoupement de la projection de matière par la ou les premières buses et la ou les deuxièmes buses pour former les jonctions électriques internes telles que décrits précédemment. Cela permet notamment d'avoir des connexions électriques formés durant le processus de dépôt des éléments thermoélectriques au moins en partie par continuité de matière et en particulier de s'affranchir des connexions par pistes métalliques additionnelles.

Dans le cas d'élément thermoélectriques multicouches, le procédé peut comporter

(a) le dépôt sous énergie concentrée de la base des éléments thermoélectriques en un premier matériau avec optionnellement les jonctions internes ou externes à la base sur le support ou sur des pistes conductrices comme décrit précédemment,
(b) le dépôt par toute méthode adaptée de la structure d'interface sur les parties des éléments thermoélectriques formés puis
(c) le dépôt par dépôt sous énergie concentrée du sommet des éléments thermoélectriques en un deuxième matériau différent du premier avec optionnellement les jonctions internes ou externes au sommet des éléments thermoélectriques comme décrit précédemment.

Dans le cas de couches intermédiaires supplémentaires en un matériau thermoélectriques, le procédé peut comporter additionnellement entre les étapes b) et c), autant de fois qu'il y a de couches intermédiaires, le dépôt sous énergie concentrée de la couche des éléments thermoélectriques en un matériau additionnel sur la structure d'interface déposée précédemment comme décrit précédemment puis le dépôt par toute méthode adaptée d'une structure d'interface sur les parties des éléments thermoélectriques formés précédemment.

Le procédé peut comporter le changement de matériau dans les réservoirs du dispositif de dépôt sous énergie concentrée pour chaque étape de dépôt. En variante, le dispositif peut comporter au moins autant de réservoir que de matériaux nécessaires au dépôt sous énergie concentrée et les différentes étapes de dépôt ci-dessus se font avec des buses différentes.

**Dépôt successif**

En variante, toutes les buses peuvent être reliées à un même réservoir de matière à déposer. Il est alors nécessaire de changer le matériau pour chaque nouveau matériau et chaque type de dopage. Le procédé peut comporter au moins une étape de changement du matériau à déposer dans le dispositif de dépôt sous énergie concentrée.

En variante encore, la formation des unités thermoélectriques peut se faire par dépôt des différents matériaux et différents dopages l'un après l'autre selon la structure des éléments thermoélectriques. Dans le cas d'éléments thermoélectriques en un unique et même matériau, le procédé peut comporter dans une première étape le dépôt de tous les éléments thermoélectriques dopés de type p puis le dépôt de tous les éléments thermoélectriques dopés de type n dans une deuxième étape. Cela peut se faire par changement du matériau à déposer dans le dispositif de dépôt sous énergie concentrée, dans le cas notamment d'un unique réservoir pour toutes les buses, et/ou par commande du dépôt par des buses différentes. Le procédé peut comporter dans ce cas optionnellement une troisième étape de formation d'une jonction électrique interne et/ou externe par dépôt d'un mélange du matériau dopé de type p et du matériau dopé de type n et/ou le dépôt de pistes métalliques pour former les jonctions électriques internes et/ou externes.

**Formation des pistes électriques**

Le procédé peut comporter une étape de dépôt de pistes métalliques sur le substrat et/ou sur les éléments thermoélectriques pour former les jonctions électriques internes et/ou externes.

Le procédé peut comporter le dépôt sur le substrat, préalablement au dépôt des éléments thermoélectriques, d'une couche métallique discontinue pour former au moins une partie des jonctions électriques internes ou externes sous la forme de pistes conductrices.

Le procédé peut comporter le dépôt sur les éléments thermoélectriques, après le dépôt des éléments thermoélectriques, d'une couche métallique discontinue pour former au moins une partie des jonctions électriques internes ou externes sous la forme de pistes conductrices.

**Substrat**

Le substrat est préférentiellement en un matériau isolant. Il peut être en céramique, notamment en AIN, mullite, CN.

Le substrat peut être de forme cylindrique de base polygonale, notamment rectangle, carré, pentagonale ou hexagonale, circulaire ou elliptique.

En variante, le substrat peut être d'une autre forme, notamment former une surface plane ou bombée ou encore une surface plus complexe.

**Série/parallèle**

De préférence, le module forme un circuit thermoélectrique entre un premier élément thermoélectrique et un dernier élément thermoélectrique, le premier et le dernier élément thermoélectrique étant reliés électriquement par une de leurs extrémités à un connecteur électrique et les éléments thermoélectriques entre le premier et le dernier élément thermoélectrique étant tous reliés électriquement à au moins deux éléments thermoélectriques adjacents pour former entre eux le circuit thermoélectrique.

Dans le cas d'un substrat de forme cylindrique, les éléments thermoélectriques peuvent être agencés selon des rangées circonférentielles dans lesquelles les éléments thermoélectriques sont électriquement reliés entre eux, deux éléments thermoélectriques de chaque rangée circonférentielle étant reliés électriquement à un élément thermoélectrique le plus proche d'une rangée antérieure et d'une rangée postérieure le long de l'axe longitudinal du substrat respectivement à l'exception de la première et dernière rangée circonférentielle qui sont chacune reliées à un connecteur électrique.

En variante, les éléments thermoélectriques peuvent être agencés selon des rangées longitudinales dans lesquelles les éléments thermoélectriques sont électriquement reliés entre eux, le premier et le dernier élément thermoélectrique de chaque rangée longitudinale étant reliés électriquement aux éléments thermoélectriques les plus proches des rangées longitudinales adjacentes à l'exception de deux rangées longitudinales adjacentes chacune reliées à un connecteur électrique.

**Eléments thermoélectriques reliés en série**

Dans chaque unité thermoélectrique, le premier élément et le deuxième élément peuvent être reliés électriquement entre eux de l'un du côté du substrat et du côté opposé au substrat uniquement. Dans ce cas, les éléments thermoélectriques sont reliés entre eux en série.

**Eléments thermoélectriques reliés en parallèle**

En variante, dans au moins une unité thermoélectrique, le premier élément et le deuxième élément sont reliés électriquement entre eux du côté du substrat et du côté opposé au substrat. Dans ce cas, au moins le circuit comporte des éléments reliés électriquement entre eux en parallèle.

**Structure support**

Le procédé peut comporter le dépôt d'une structure support sur le substrat, la structure support comportant des éléments supports configurés pour s'étendre entre les éléments thermoélectriques et servir de support au dépôt des éléments thermoélectriques durant le dépôt sous énergie concentrée de ces derniers. Ce dépôt se fait de préférence préalablement au dépôt des éléments thermoélectriques sous énergie concentrée.

Les éléments supports peuvent comporter un matériau isolant électriquement et/ou un matériau sacrificiel.

Dans le cas d'éléments thermoélectriques inclinés par rapport à l'axe perpendiculaire au substrat à leur base, les éléments supports peuvent s'étendre sous les éléments thermoélectriques. Cela permet de faciliter le dépôt des éléments thermoélectriques par le dépôt sous énergie concentrée.

Dans le cas d'éléments thermoélectriques en contact l'un avec l'autre, les éléments supports peuvent s'étendre entre les éléments TE en contact entre eux à leur sommet.

De préférence, les éléments supports sont tous identiques et en un même matériau.

Ils peuvent être déposés par toute méthode adaptée sur le substrat, notamment par impression 3D, notamment par la méthode de dépôt sous énergie concentré. Au moins une des buses du dispositif de dépôt sous énergie concentrée peut être connectée à un réservoir contenant le matériau constituant les éléments supports.

Les éléments supports peuvent être de conductivité thermique inférieure ou égale à celle des éléments thermoélectriques.

Les éléments supports peuvent être en un matériau isolant électriquement. Le matériau isolant électriquement peut être une céramique, notamment en silice, mica ou Macor®. La céramique peut être pleine ou poreuse.

En variante, les éléments supports sont en un matériau sacrificiel, le procédé comportant en outre une étape de retrait du matériau sacrificiel par une méthode appropriée, notamment par voie chimique ou par chauffage. Le matériau sacrificiel peut être en céramique ou métal, notamment en silice ou en nitrure d'aluminium., il est possible d'avoir des éléments supports uniquement apparents durant le procédé de fabrication mais qui ne sont plus apparents sur le module thermoélectrique et forment des zones creuses.

En variante, les éléments supports peuvent comporter une structure plus complexe, notamment comporter une couche de peau et une couche de cœur. La couche de peau peut être en un matériau isolant électriquement et la couche de cœur en un matériau sacrificiel.

**Etapes additionnelles**

Le procédé peut comporter, après formation des unités thermoélectriques, une étape de recuit. L'étape de recuit peut comporter la chauffe du module formé à une température supérieure ou égale à supérieure ou égale à 100°C dans un four sous atmosphère inerte, notamment d'Argon. Un tel recuit permet notamment de modifier la microstructure des éléments thermoélectriques pour améliorer la microstructure du module formé. Cela peut permettre en outre de réduire les contraintes mécaniques accumulées dans le module durant la fabrication et donc d'améliorer les propriétés mécaniques et thermoélectriques du module thermoélectrique.

**Brève description des dessins**

[Fig 1] représente schématiquement en coupe transversale un exemple de module thermoélectrique cylindrique,

[Fig 2] représente schématiquement un exemple de procédé,

[Fig 3] représente schématiquement une variante de module thermoélectrique,

[Fig 4] représente schématiquement différentes variantes de formes de plots thermoélectriques,

[Fig 5] représente schématiquement en coupe transversale une variante de module thermoélectrique,

[Fig 6] représente schématiquement en coupe transversale une variante de module thermoélectrique,

[Fig 7] représente schématiquement en coupe transversale une variante d'unité thermoélectrique,

[Fig 8] représente schématiquement une variante de procédé,

[Fig 9] représente schématiquement une variante de procédé,

[Fig 10] représente schématiquement une variante de structure de support, et

[Fig 11] représente schématiquement une variante de procédé.

[Fig 12] représente schématiquement en coupe transversale une variante d'un module thermoélectrique.

**Description détaillée**

Dans la suite de la description, les éléments identiques ou de fonctions identiques 10 portent le même signe de référence. A des fins de concision de la présente description, ils ne sont pas décrits en regard de chacune des figures, seules les différences entre les modes de réalisation étant décrites.

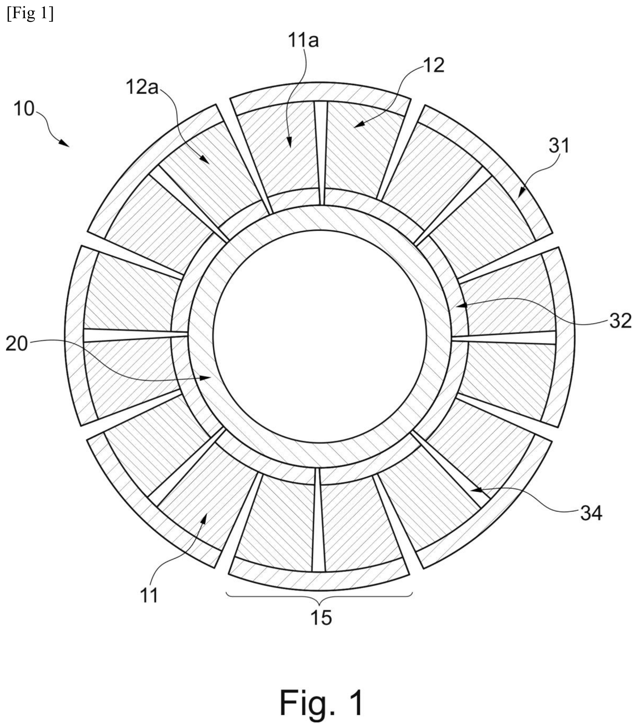

On a illustré à la figure 1 un module thermoélectrique (10), comportant un substrat (20) cylindrique à base circulaire, portant des unités thermoélectriques (15) reliées entre elles électriquement par des jonctions électriques externe (32). Le substrat est préférentiellement en un matériau isolant. Il peut être en céramique, notamment en AIN, mullite, CN.

Les unités thermoélectriques comportent chacun deux éléments thermoélectriques (11, 12) dopés différemment reliés entre eux par des jonctions électriques internes (31). Les unités thermoélectriques (15) sont agencées sur le substrat (20) pour que les éléments thermoélectriques (11, 12) soient de dopages alternés autour du substrat (20).

Dans le mode de réalisation de la figure 1, les unités thermoélectriques (15) sont toutes identiques. Cependant, l'invention n'est pas limitée à des unités thermoélectriques (15) identiques. Au moins deux unités thermoélectriques (15) pourraient être de formes différentes.

Dans le mode de réalisation de la figure 1, les deux éléments thermoélectriques (11, 12) des unités thermoélectriques (15) sont de formes identiques. L'invention n'est pas limitée à des éléments thermoélectriques (11, 12) de formes identiques. Ces derniers pourraient présenter des formes différentes ou être de formes identiques mais agencées tête-bêche comme nous le verrons par la suite.

Les éléments thermoélectriques (11, 12) sont ici chacun sous forme de plot allongé selon un axe longitudinal, correspondant à un axe radial du substrat (20) et sont symétriques par rapport à cet axe longitudinal. Les éléments thermoélectriques (11, 12) sont de largeur croissante le long de l'axe longitudinal de leur base vers leur sommet. Ils présentent en section transversale du substrat des parois latérales (34) rectilignes s'étendant chacune radialement au substrat (20). Cela permet de limiter les espaces vides entre les éléments thermoélectriques (31, 32). Les éléments thermoélectriques peuvent être en matériau thermoélectrique, tels que le silicium (Si), en un alliage de silicium et germanium (SiGe), tellurure de bismuth (Bi2Te3), skuttérudites, en un alliage Half Heusler ou en Tellurure de plomb.

Les jonctions électriques internes (31) sont ici des pistes métalliques agencées au sommet des éléments thermoélectriques formés par une couche métallique discontinue déposée sur les éléments thermoélectriques (11, 12).

Les jonctions électriques externes (32) sont ici des pistes métalliques agencées sur le substrat (20) formés par une couche métallique discontinue déposée sur le substrat (20).

Dans ce mode de réalisation, les éléments thermoélectriques (11, 12) sont reliés entre eux en séries, chaque élément thermoélectrique (11, 12), à l'exception du premier et du dernier élément thermoélectrique de la série, étant relié à sa base à un élément thermoélectrique adjacent par une des connexions électriques (32) et à son sommet à un autre élément thermoélectrique adjacent par une des connexions électrique (31). Le premier et le dernier élément thermoélectrique de la série sont reliés chacun à une élément thermoélectrique adjacent par l'un de leur base et de leur sommet et à un connecteur électrique vers l'extérieur, non représenté, par l'autre de leur base et de leur sommet. Les éléments thermoélectriques (11, 12) peuvent être agencés selon des rangées circonférentielles dans lesquelles les éléments thermoélectriques sont électriquement reliés entre eux par les jonctions électriques internes et externes (31, 32), deux éléments thermoélectriques (11a, 12a) de chaque rangée circonférentielle étant reliés électriquement à un élément thermoélectrique le plus proche d'une rangée antérieure et d'une rangée postérieure le long de l'axe longitudinal du substrat respectivement à l'exception de la première et dernière rangée circonférentielle qui sont chacune reliées à un connecteur électrique.

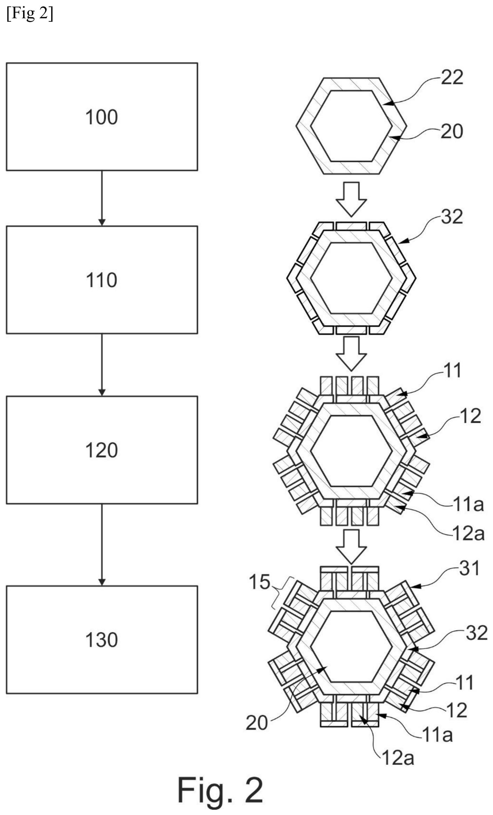

On a illustré à la figure 2 un procédé de fabrication d'une variante de module thermoélectrique (10). Le module thermoélectrique (10) formé est similaire à celui de la figure 1. Les seules différences sont que le substrat (20) est hexagonal en section et non circulaire comme cela est le cas sur la figure 1 et que les élément thermoélectriques (11, 12) sont de forme parallélépipédique et donc de largeur constante sur toute leur hauteur. Chaque face (22) du substrat porte une ou plusieurs unités thermoélectriques (15), ici deux unités thermoélectriques (15). Les unités thermoélectriques (15) de bases différentes sont reliées entre elles par des jonctions externes (32) à leur base sous forme de pistes métalliques s'étendant entre les deux faces correspondantes. Dans ce mode de réalisation les unités thermoélectriques sont chacune sur une face. Néanmoins, il est possible, sans sortir du cadre de cette invention d'avoir une ou plusieurs unités thermoélectriques (15) à cheval sur deux faces adjacentes.

Dans ce procédé de fabrication, la première étape (100) consiste à fournir le substrat (20) sur lequel est déposé les pistes métalliques (32) formant les jonctions électriques externes dans une seconde étape (110). Le dépôt des pistes métalliques peut être réalisé en une ou plusieurs couches par toute méthode de dépôt.

Les éléments thermoélectriques (11, 12) sont ensuite déposés en étape (120) sur les pistes métalliques (32). Le dépôt des éléments thermoélectriques (11, 12) est réalisé par une méthode de dépôt sous énergie concentrée à l'aide d'un dispositif adapté.

Le dispositif de dépôt sous énergie concentrée peut comporter une pluralité de buses dont au moins une ou des premières buses sont reliées à un réservoir de poudre en un matériau dopé p et une ou des deuxièmes buses sont reliées à un réservoir de poudre dopée n. Le dépôt des éléments thermoélectriques (11, 12) peut alors se faire par dépôt successifs des éléments thermoélectriques (11, 12) adjacents sur les pistes métalliques (32). La ou les premières buses peuvent alors projeter le matériau dopé p pour former un élément thermoélectrique (11), puis la ou les deuxièmes premières buses peuvent projeter le matériau dopé n pour former un élément thermoélectrique (12) adjacent, par exemple de la même unité thermoélectrique (15) ou de l'unité thermoélectrique (15) adjacente et ainsi de suite jusqu'à former l'intégralité des éléments thermoélectriques (11, 12). En variante, l'étape de dépôt comporte le dépôt de tous les éléments thermoélectriques d'un dopage puis le dépôt de tous les éléments thermoélectriques de l'autre dopage.

En variante, le dispositif de dépôt sous énergie concentrée comporte une unique buse ou toutes ses buses sont reliées à un ou plusieurs réservoirs contenant un matériau d'un dopage. Le procédé de dépôt est alors similaire à celui décrit précédemment sauf qu'il faut changer le ou les réservoirs et/ou le ou les contenus des réservoirs pour pouvoir procéder au dépôt des éléments thermoélectriques des deux dopages.

Enfin en étape 130, les pistes métalliques (31) sont déposées sur les éléments thermoélectriques (11,12) pour connecter les éléments thermoélectriques entre eux à leurs sommets, dans le cas présent pour connecter les unités thermoélectriques (15) entre elles.

Le procédé peut comporter, après formation des unités thermoélectriques (11, 12), une étape additionnelle de recuit non illustré. L'étape de recuit peut comporter la chauffe du module formé à une température supérieure ou égale à 100°C dans un four sous atmosphère inerte, notamment sous atmosphère d'Argon.

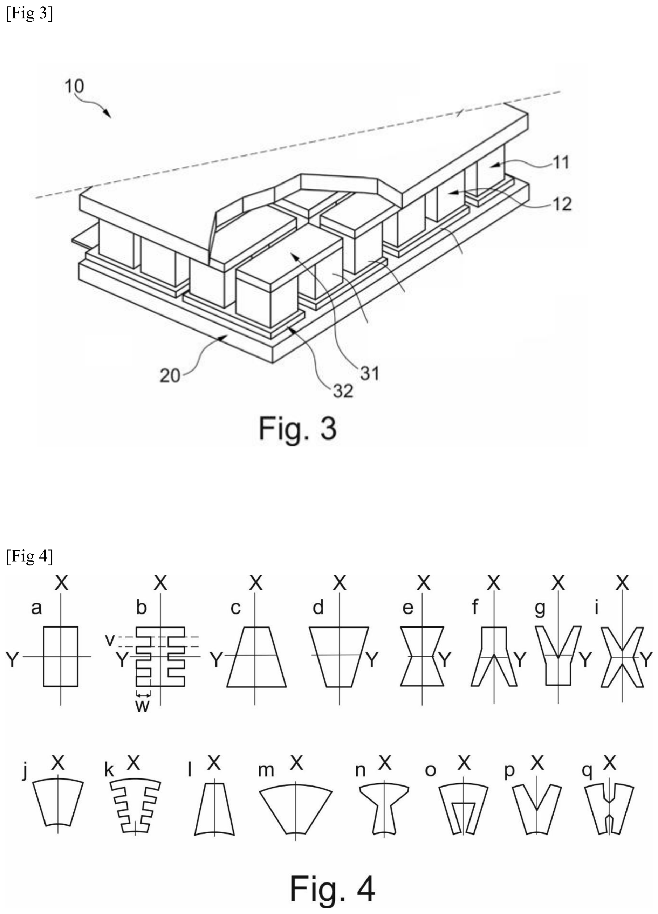

Le module thermoélectrique (10) de la figure 3 diffère des précédents modules illustrés en ce que le substrat (20) est plan. Les éléments thermoélectriques sont également parallélépipédiques.

L'invention n'est pas limitée à une forme des éléments thermoélectriques (11, 12) particulières. De nombreuses variantes de formes peuvent être envisagées. La figure 4 en présente quelques-unes. Sur la ligne supérieure, allant de a à i, les formes correspondent à des éléments thermoélectriques déposés sur une surface du substrat (20) plane et sur la ligne inférieure, allant de j à q, à des éléments thermoélectriques déposés sur une surface courbée du substrat (20). Néanmoins, les formes de la ligne supérieure sont adaptées à un dépôt sur une surface courbe moyennant l'adaptation de la base et les forme de la ligne inférieure moyennant sont adaptées à un dépôt sur une surface plane moyennant quelques petites adaptations à la portée de l'homme du métier. Les éléments thermoélectriques s'étendent de préférence selon un axe longitudinal (X). Les éléments thermoélectriques a, b, e, i sont symétriques par rapport à leur plan médian perpendiculaire à leur axe longitudinal (X). Les éléments thermoélectriques c, d, f, g ne sont pas symétriques par rapport à leur plan médian (Y) perpendiculaire à l'axe longitudinal X. L'élément thermoélectrique b, présente des évidements latéraux, d'une épaisseur v et d'une profondeur w. Les éléments thermoélectriques c et d présentent chacun des surfaces à leur base et à leur sommet différentes. Les éléments thermoélectriques c et d sont de formes complémentaires et peuvent être alignés de façon alternée pour rapprocher les éléments thermoélectriques. L'élément thermoélectrique e, présente entre son sommet et sa base une largeur latérale inférieure à la largeur du sommet et de la base, étant en forme de sablier. Les éléments thermoélectriques f, g et i possèdent des branches qui s'étendent vers la base pour l'élément f, vers le sommet pour l'élément g et vers le sommet et la base pour l'élément i, en forme de X.

Les éléments thermoélectriques i, j, k, l, m, n, o, p, q correspondent aux éléments a, b, c, d, e, f, g, h, adaptés à une surface de contact du substrat courbe sur lequel ils sont déposés. Dans ce cas-ci, le substrat possède une surface courbe et les éléments thermoélectriques possèdent de préférence à leur base et à leur sommet le même rayon de courbure que le substrat.

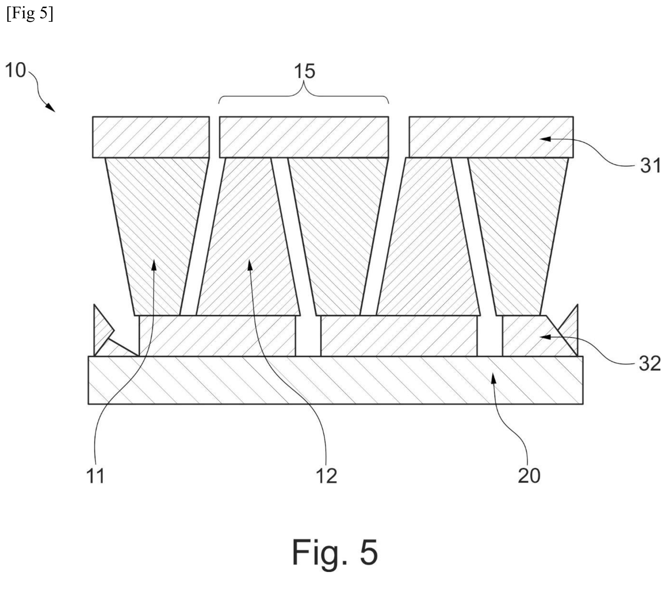

On a illustré à la figure 5, un module thermoélectrique (10) dont la surface du substrat (20) est plane. Les éléments thermoélectriques (11, 12) dopés différemment sont de formes différentes. Chaque unité thermoélectrique (15) comporte un élément thermoélectrique (11) de forme trapézoïdale avec le grand côté formant la base et un élément thermoélectrique (11) de forme trapézoïdale avec le grand côté formant le sommet. Les deux éléments thermoélectriques (11, 12) présentent des surfaces latérales de formes complémentaires. Toutes les unités thermoélectriques (15) peuvent être identiques.

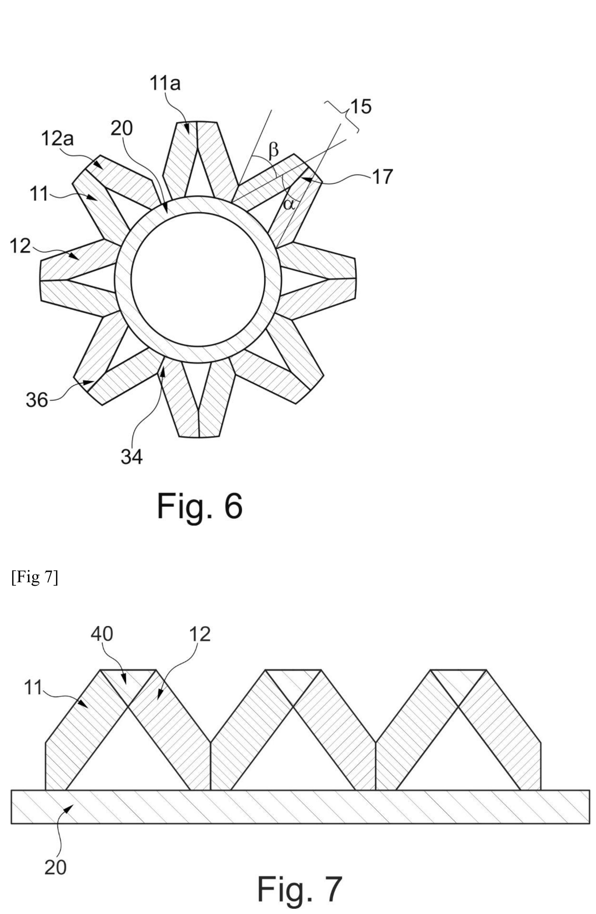

Le module thermoélectrique de la figure 6 diffère de celui de la figure 1 en ce que les éléments thermoélectriques (11, 12) de chaque unité thermoélectrique (15) ont des axes d'élongation différents d'une élongation radiale en formant entre eux un angle $\alpha$ compris entre 5° et 70°. L'angle $\alpha$ est sensiblement égal à 360/n, n étant le nombre d'unités thermoélectriques agencées autour d'une section transversale du substrat, ici sensiblement égal à 45°. Les connexions peuvent être réalisées par des pistes métalliques ou comme illustré sur la figure par contact entre les éléments thermoélectriques (11, 12) adjacents. Dans ce cas, la surface de contact (17) entre les éléments thermoélectriques est de préférence supérieure ou égale à 50% de la section transversale d'un élément thermoélectrique. Chaque élément thermoélectrique peut former un angle β avec l'axe radial à la base sensiblement égal à l'angle α. Dans l'exemple illustré tous les éléments thermoélectriques forment le même angle avec l'axe radial. Cependant, il pourrait en être autrement, en particulier les éléments thermoélectriques d'un dopage pourrait former un premier angle et les éléments thermoélectriques de l'autre dopage former un deuxième angle différent du premier avec leur axe radial. Dans ce mode de réalisation, les éléments thermoélectriques sont reliés entre eux par contact à leur base et leur sommet. Néanmoins, ils pourraient ne l'être par contact que à leur base ou que à leur sommet, l'autre connexion se faisant par des pistes métalliques.

Sur la figure 6, les éléments thermoélectriques sont reliés entre eux par contact. Cependant ils pourraient être reliés entre eux par une jonction (40) formée d'un mélange de matière dopée p et de matière dopée n à leur jonction comme cela est illustré sur la figure 7. Cette jonction (40) peut être formée par l'utilisation d'un dispositif à dépôt sous énergie concentrée comportant plusieurs buses reliées à des réservoirs différents contenant le matériau dopé p et le matériau dopée n respectivement et par projection simultanée des deux matériaux à la jonction entre les deux éléments thermoélectriques (11, 12). Le procédé de fabrication peut alors comporter une séquence de projections coordonnées avec le déplacement des buses sur le substrat comportant une première projection d'un matériau d'un premier dopage pour former un premier élément thermoélectrique (11) par la ou les premières buses, puis une deuxième projection d'un matériau d'un deuxième dopage pour former un deuxième élément thermoélectrique (12) par la ou les deuxièmes buses, la première et la deuxième projection étant simultanée à la jonction entre les deux éléments thermoélectriques (11, 12) pour former la jonction (40) par mélange des deux matériaux. De préférence, les matériaux formant les éléments thermoélectriques sont identiques. Seul leur dopage change.

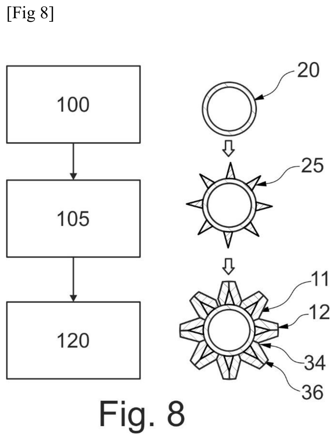

On a illustré à la figure 8, un procédé de fabrication d'un module (10), comportant la fourniture d'un substrat (20) selon l'étape 100, puis à l'étape 105 le dépôt d'une structure support (25) sur le substrat (20), suivi du dépôt des éléments thermoélectriques (11, 12) par dépôt d'énergie concentrée sous la même forme qu'à la figure 6, c'est-à-dire par jonction par contact ou mélange local sans piste métallique. La structure support (25) comporte des éléments supports déposés à intervalle régulier sur le substrat (20) qui facilitent la fabrication des éléments thermoélectriques inclinés par rapport à l'axe radial en permettant leur formation directement sur la surface de ces structures supports (25). De préférence les structures supports (25) sont de forme complémentaire des espaces sous les éléments thermoélectriques, notamment triangulaire. Le dépôt de la structure support peut se faire par tout moyen connu. De préférence, de tels éléments supports peuvent être de conductivité thermique inférieure ou égale à celle des éléments thermoélectriques (11, 12)], notamment en un matériau isolant, par exemple en céramique ou silice, pleine ou poreuse.

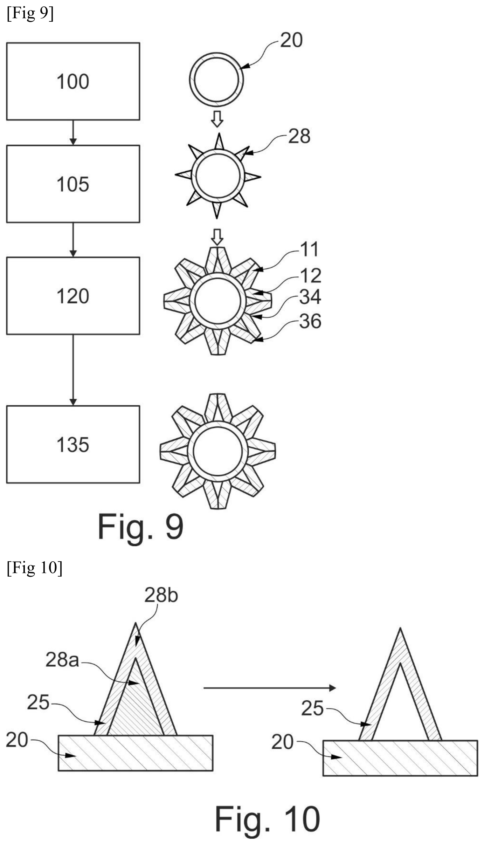

On a illustré à la figure 9, un procédé de fabrication d'un module thermoélectrique (10) similaire à celui de la figure 8. Dans ce mode de réalisation, la structure support est formée d'éléments sacrificiels (28) en un matériau sacrificiel. Le procédé peut comporter alors une étape 135 de retrait du matériau sacrificiel par une méthode appropriée, notamment par voie chimique ou par chauffage. Le matériau sacrificiel peut être en céramique ou métal, notamment en silice ou en nitrure d'aluminium.

En variante illustrée sur la figure 10, la structure support comporte une partie interne (28a) en un matériau sacrificiel et une partie externe (28b) en un matériau non sacrificiel. A l'étape 105, la partie interne (28a) en matériau sacrificiel est déposée sur le substrat (20), suivie d'un second dépôt en un second matériau recouvrant le matériau sacrificiel (28b). A une étape ultérieure la partie intérieure (28a) de la structure support (25) est retirée et seul reste la partie externe (28b) de la structure support. L'étape de retrait peut être après la formation des éléments thermoélectriques ou après.

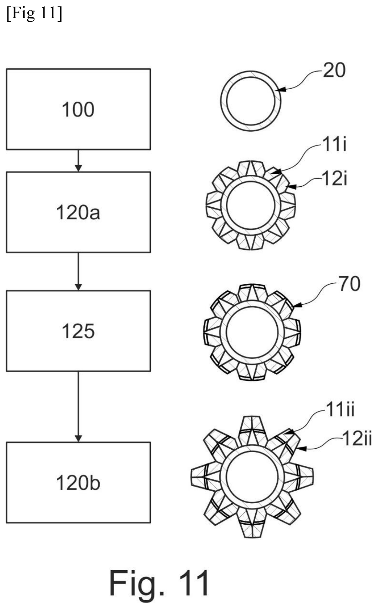

La figure 11 illustre un autre procédé de fabrication d'une variante de module thermoélectrique. Le module thermoélectrique (10) diffère de celui de la figure 6 en ce que chaque élément thermoélectrique (11, 12) est formé d'une structure multicouche comportant, de la base vers le sommet, une première couche (11i, 12i) en un premier matériau déposé à l'étape 120a par dépôt sous énergie concentré comme décrit précédemment, une interface (70) en une couche en un ou plusieurs matériaux formant une barrière de diffusion déposée par tout moyen à l'étape 125, notamment en cuivre ou nickel et une deuxième couche (11ii, 12ii) en un deuxième matériau déposé à l'étape 120b par dépôt sous énergie concentré comme décrit précédemment. L'invention n'est pas limitée à une structure mulicouche comportant uniquement deux couches. Une structure plus complexe est possible par dépôt successifs.

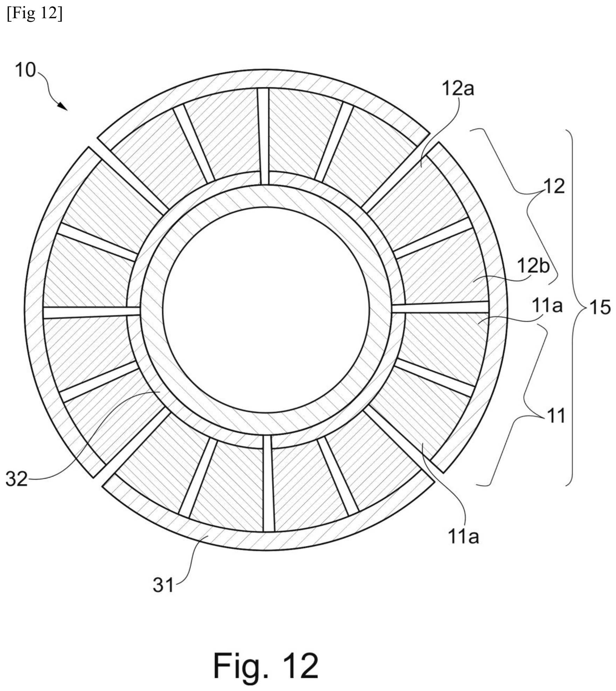

On a illustré à la Figure 12, une variante d'un module thermoélectrique (10), dans laquelle, dans au moins une unité thermoélectrique (15b), le premier élément thermoélectrique (11) et le deuxième élément thermoélectrique (12) sont formés chacun de deux plots (11a, 11b ; 12a, 12b) de même dopage. Les deux plots de chaque élément sont reliés électriquement entre eux du côté du substrat et du côté opposé au substrat en parallèle. Les éléments thermoélectriques (11, 12) des unités thermoélectriques (15) sont quant à eux reliés entre eux par le côté opposé au substrat, ici par des connexions électriques (31) et les unités thermoélectriques sont reliées entre elles du côté du substrat, ici par des connexions électriques (32). L'invention n'est pas limitée à un ou deux plots par éléments thermoélectriques. Les éléments thermoélectriques peuvent comporter plus de deux plots selon les performances recherchées et le cahier des charges.

L'invention n'est également pas limitée à un même nombre de plots pour les deux éléments thermoélectriques des unités thermoélectriques. Le premier élément pourrait par exemple avoir un unique plot et le deuxième élément avoir deux plots.

L'invention n'est pas limitée aux exemples qui viennent d'être décrits. L'homme du métier saura combiner les enseignements des différents modes de réalisation pour réaliser des variantes non décrites.

Par exemple, les éléments thermoélectriques des figures 1 et 2 peuvent être chacune d'une structure multicouche comme décrit en relation avec la figure 11.

**Revendications**

1. Procédé de fabrication d'un module thermoélectrique (10) permettant de générer un effet thermoélectrique, comprenant au moins les étapes de :

   (a) Fourniture d'un substrat (20),
   (b) Formation sur le substrat (20) d'une pluralité d'unités thermoélectriques (15) comportant chacune deux éléments thermoélectriques (11, 12) dopés selon des types de dopage différents, les deux éléments thermoélectriques (11, 12) étant reliés électriquement entre eux du côté du substrat (20) et/ou du côté opposé au substrat (20), les deux éléments thermoélectriques (11, 12) étant au moins partiellement formés par une méthode de dépôt sous énergie concentrée.

2. Procédé de fabrication d'un module thermoélectrique (10) selon la revendication 1, les deux éléments thermoélectriques (11, 12) d'une même unité thermoélectrique (15), étant reliés électriquement par contact direct entre eux ou par une jonction électrique interne (31).

3. Procédé de fabrication d'un module thermoélectrique (10) selon la revendication 2, les jonctions électriques internes (31) et/ou des jonctions électriques externes (32) étant formées par le dépôt local entre les deux éléments thermoélectriques (11, 12) d'une couche d'un mélange des deux matériaux composant les deux éléments thermoélectriques ou le dépôt d'une piste métallique en contact avec les deux éléments thermoélectriques (11, 12).

4. Procédé de fabrication d'un module thermoélectrique (10) selon l'une quelconque des revendications précédentes, les éléments thermoélectriques (11, 12) étant allongés selon un axe longitudinal (X) et asymétriques par rapport à leur axe médian (Y) perpendiculaire à l'axe longitudinal (X).

5. Procédé de fabrication d'un module thermoélectrique (10) selon l'une quelconque des revendications précédentes, les éléments thermoélectriques (11, 12) des unités thermoélectriques (15) étant de formes complémentaires, notamment sensiblement imbriquables entre elles.

6. Procédé de fabrication d'un module thermoélectrique (10) selon l'une quelconque des revendications précédentes, le substrat (20) étant de forme cylindrique à base polygonale, notamment rectangle, carré, pentagonale ou hexagonale, circulaire ou elliptique.

7. Procédé de fabrication d'un module thermoélectrique (10) selon l'une quelconque des revendications précédentes, comportant le dépôt d'une structure support sur le substrat, la structure support (25) comportant des éléments supports (25, 28) configurés pour s'étendre entre les éléments thermoélectriques (11, 12) et servir de support au dépôt des éléments thermoélectriques durant le dépôt sous énergie concentrée de ces derniers, les éléments supports (25, 28) comportant notamment un matériau isolant électriquement et/ou un matériau sacrificiel (28).

8. Procédé de fabrication d'un module thermoélectrique (10) selon l'une quelconque des revendications précédentes, le dépôt sous énergie concentrée étant effectué à l'aide d'un dispositif comportant une pluralité de buses de projection de matière à déposer, au moins une ou plusieurs premières buses étant reliées à un ou plusieurs réservoirs contenant un matériau dopé de type n pour former un des éléments thermoélectriques de chaque unité thermoélectrique (15) au moins en partie et au moins une ou plusieurs autres deuxièmes buses étant reliées à un ou plusieurs réservoirs contenant un matériau dopé de type p pour former l'autre des éléments thermoélectriques de chaque unité thermoélectrique au moins en partie.

9. Procédé de fabrication d'un module thermoélectrique (10) selon la revendication précédente, la formation des unités thermoélectriques (15) au moins en partie se fait par le dépôt alterné d'un matériau dopé de type p et d'un matériau dopé de type n pour chaque unité thermoélectrique (15) en alternant la projection de matière par la ou les premières buses et la ou les deuxièmes buses.

10. Procédé de fabrication d'un module thermoélectrique (10) selon la revendication 8 par son rattachement à la revendication 3, les jonctions électriques internes (31) et/ou externes (32) peuvent être formées par le dépôt local entre les deux éléments thermoélectriques (11, 12) d'une couche d'un mélange des deux matériaux composant les deux éléments thermoélectriques (11, 12), notamment réalisé par dépôt sous énergie concentrée, notamment par le dépôt simultané des deux matériaux de dopages différents par la ou les premières et la ou les deuxièmes buses, les éléments thermoélectriques (11, 12) étant de préférence inclinés sur le substrat (20) par rapport à l'axe perpendiculaire du substrat à leur base dans des directions opposées, notamment d'un angle α compris entre 5° et 70°, l'angle pouvant dépendre des performances thermoélectriques attendues, de la tenue mécanique nécessaire, des matériaux et/ou de la hauteur des éléments.

11. Procédé de fabrication d'un module thermoélectrique (10) selon l'une quelconque des revendications précédentes, les éléments thermoélectriques (11, 12) comportant plusieurs couches de matériaux différents dopés avec le même type de dopage, notamment séparées entre elles par une ou plusieurs structures d'interface (70).

12. Procédé de fabrication d'un module thermoélectrique (10) selon la revendication précédente dans son rattachement à la revendication 3, comportant :

(a) le dépôt sous énergie concentrée de la base des éléments thermoélectriques (11i, 12i) en un premier matériau avec optionnellement les jonctions internes ou externes à la base sur le support ou sur des pistes conductrices,
(b) le dépôt par toute méthode adaptée de la structure d'interface (70) sur les parties des éléments thermoélectriques formés puis
(c) le dépôt par dépôt sous énergie concentrée du sommet des éléments thermoélectriques (11ii, 12ii) en un deuxième matériau différent du premier avec optionnellement les jonctions internes (31) ou externes (32) au sommet des éléments thermoélectriques.

13. Procédé de fabrication d'un module thermoélectrique (10) selon l'une quelconque des revendications précédentes, le module formant un circuit thermoélectrique entre un premier élément thermoélectrique et un dernier élément thermoélectrique, le premier et le dernier élément thermoélectrique étant reliés électriquement par une de leurs extrémités à un connecteur électrique et les éléments thermoélectriques entre le premier et le dernier élément thermoélectrique étant tous reliés électriquement à au moins deux éléments thermoélectriques adjacents pour former entre eux le circuit thermoélectrique.

14. Procédé de fabrication d'un module thermoélectrique (10) selon l'une quelconque des revendications précédentes, le premier élément et le deuxième élément d'une unité thermoélectrique (15) étant reliés électriquement en série entre eux de l'un du côté du substrat et du côté opposé au substrat uniquement, ou le premier et le deuxième élément d'une unité thermoélectrique (15) étant reliés électriquement en parallèle entre eux du côté du substrat et du côté opposé au substrat.

15. Module thermoélectrique (10) fabriqué par le procédé de fabrication selon l'une quelconque des revendications précédentes.

[Fig 1]

Fig. 1

[Fig 2]

Fig. 2

[Fig 3]

Fig. 3

[Fig 4]

Fig. 4

[Fig 5]

Fig. 5

Fig. 6

[Fig 7]

Fig. 7

[Fig 8]

Fig. 8

[Fig 9]

Fig. 9

[Fig 10]

Fig. 10

[Fig 11]

Fig. 11

[Fig 12]

Fig. 12

Europäisches
Patentamt

European
Patent Office

Office européen
des brevets

## RAPPORT DE RECHERCHE EUROPEENNE

**Numéro de la demande**

EP 25 21 5340

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | EL-DESOUKY AHMED ET AL: "Rapid processing and assembly of semiconductor thermoelectric materials for energy conversion devices", MATERIALS LETTERS, vol. 185, 1 août 2016 (2016-08-01), pages 598-602, XP029810531, ISSN: 0167-577X, DOI: 10.1016/J.MATLET.2016.07.152 | 1-6, 13-15 | INV. H10N10/01 H10N10/17 B22F10/28 B22F5/10 B22F7/06 B22F7/08 B22F10/25 |
| A | * figures 1,2 * ----- | 7-12 | |
| A | OZTAN CAGRI ET AL: "Additive Manufacturing of Bulk Thermoelectric Architectures: A Review", ENERGIES, vol. 15, no. 9, 25 mai 2022 (2022-05-25), page 3121, XP093113437, CH ISSN: 1996-1073, DOI: 10.3390/en15093121 * page 7, alinéa 1 - page 10, alinéa 3; figure 4 * ----- | 1-15 | |
| A,D | FR 3 140 994 A1 (COMMISSARIAT ENERGIE ATOMIQUE [FR]) 19 avril 2024 (2024-04-19) * alinéa [0137] - alinéa [0142]; figures 2A-2D * * alinéa [0154] - alinéa [0159]; figures 4A-4D * ----- | 1-15 | DOMAINES TECHNIQUES RECHERCHES (IPC) H10N C22C B22F |

Le présent rapport a été établi pour toutes les revendications

| Lieu de la recherche | Date d'achèvement de la recherche | Examinateur |
|---|---|---|
| La Haye | 15 décembre 2025 | Kirkwood, Jonathan |

EPO FORM 1503 03.82 (P04C02)

**EP 4 746 664 A1**

## ANNEXE AU RAPPORT DE RECHERCHE EUROPEENNE
## RELATIF A LA DEMANDE DE BREVET EUROPEEN NO.

EP 25 21 5340

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

15-12-2025

| Document brevet cité au rapport de recherche | Date de publication | Membre(s) de la famille de brevet(s) | Date de publication |
|---|---|---|---|
| FR 3140994 A1 | 19-04-2024 | CN 117897031 A | 16-04-2024 |
| | | EP 4355063 A1 | 17-04-2024 |
| | | FR 3140994 A1 | 19-04-2024 |
| | | US 2024130237 A1 | 18-04-2024 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3985745 A
- FR 3140994
- FR 3140993

**Littérature non-brevet citée dans la description**

- **J. LEE** ; **S. CHOO** ; **H. JU** ; **J. HONG** ; **S. E. YANG** ; **F. KIM** ; **D. H. GU** ; **J. JANG** ; **G. KIM** ; **S. AHN**. *Doping-Induced Viscoelasticity in PbTe Thermoelectric Inks for 3D Printing of Power-Generating Tubes. Adv. Energy Mater.*, 2021, vol. 11, 2100190

- **HUE et al.** ACS Applied Materials and Interfaces. *3D Printing of Bi2Te3-Based Thermoelectric Materials with High Performance and Shape Controllability*, 2023, vol. 15 (32)